# EUROPEAN PATENT SPECIFICATION

(11) **EP 0 715 636 B1**
(45) Date of publication and mention of the grant of the patent: **17.09.1997**
(21) Application number: 94926176.2
(22) Date of filing: 10.08.1994
(51) Int. Cl.: C08F 283/10, B32B 27/38, H05K 1/03

(54) **ALLYL-EPOXY IPN**
ALLYL-EPOXY-IPN
Réseau polymère interpénétré allyle-époxy

(30) Priority: 23.08.1993 NL 9301456
(43) Date of publication of application: 12.06.1996
(73) Proprietor: Akzo Nobel N.V., 6824 BM Arnhem (NL)
(72) Inventor: SCHUTYSER, Jan, André, Jozef, NL-6952 JJ Dieren (NL); BUSER, Antonius, Johannes, Wilhelmus, NL-7031 DA Wehl (NL)
(74) Representative: Schalkwijk, Pieter Cornelis
(86) International application number: EP9402664
(87) International publication number: WO9506075

(56) References cited:
- EP-A- 0 413 386
- DATABASE WPI Section Ch, Week 9238, Derwent Publications Ltd., London, GB; Class A21, AN 92-311923 'epoxy contained resin compsn. for package of semiconductor -comprises allyl contained prepolymer contg. both terminals epoxy ...' & JP,A,4 216 818 (SUMITOMO BAKELITE CO.) 6 August 1992 cited in the application
- PATENT ABSTRACTS OF JAPAN vol. 016, no. 356 (C-0969) 31 July 1992 & JP,A,4 108 860 (MATSUSHITA ELECTRIC WORKS LTD) 09 April 1992
- Printed Circuit Handbook; Clyde F. Coombs, Jr.; chapter 6.1
- DATABASE WPI Section Ch, Week 9238, Derwent Publications Ltd., London, GB; Class A21, AN 92-311923 'epoxy contained resin compsn. for package of semiconductor -comprises allyl contained prepolymer contg. both terminals epoxy ...' & JP,A,4 216 818
- PATENT ABSTRACTS OF JAPAN vol. 016, no. 356 (C-0969) 31 July 1992 & JP,A,4 108 860

## Description

The invention pertains to an interpenetrating polymer network (IPN) composed of
(1) epoxy network forming compounds comprising
   (a) polyfunctional epoxy compounds;
   (b) polyfunctional aromatic hydroxyl compounds;
(2) allyl network forming compounds;
in which the (1):(2) weight ratio is in the range of 95:5 to 40:60.

Such IPNs have very favourable properties, particularly for use in the electronics industry, and are known from US 5,210,157.

The favourable properties of said known IPNs are attributable largely to the constituents selected (cyclic moiety-containing allyl compounds which are cross-linked in the presence of a radical initiator and epoxy resin cross-linked with the aid of a polyhydric phenol). Very good properties are obtained with the known IPNs when approximately 40-60 weight percent of the IPN is composed of epoxy resin, with optimum results being obtained when triallyl cyanurate monomer or prepolymer (TAC) or triallyl isocyanurate (TAIC) is used as the allyl compound. This shows itself, e.g., in a high Tg. The Tg, it turns out, is affected by, among others, the allyl to epoxy ratio, it being the case that a larger amount of epoxy resin will lead to a lower Tg. The Tg is also affected by the type of cyclic moiety-containing allyl compound. For instance, the known IPNs tend to have a lower Tg when the allyl compound selected is diallyl phthalate (instead of, say, triallyl cyanurate).

It is now desired to provide IPNs which have the favourable properties, particularly for the electronics industry, of the aforementioned known IPNs, but which in addition show enhanced properties (notably: high Tg, low thermal expansion, sufficient fire retardancy at a lower bromine content, high copper peel strength) not only for the preferred embodiments of the known IPNs, but especially for compositions with a comparatively large epoxy resin constituent or for compositions (also) containing allyl compounds other than TAC or TAIC.

Further prior art background is formed by US 4,661,568 (Koenig), WO 82/1877 (Whiteside), neither of which relates to IPNs but to epoxy resin, US 4,755,571 (Irving), and GB 994,484.

Described in Koenig is an epoxy resin composition comprising an epoxy resin, a solvent, and a hardener which is the reaction product of a polyhydric phenol and a hexa-alkyl ether of a particular methylol melamine. The disclosed epoxy resins have a comparatively high Tg (150°-170°C) and are utilised in electronic laminates. The ratio of phenolic hydroxyl to epoxy is in the range of 0.5:1 to 2:1., preferably in the range of 0.8:1 to 1.2:1. A drawback to the described hardener consists in that the discharge of methanol may cause objectionable blistering. In addition, Koenig's prepreg manufacture employs a temperature which is unfavourably low in view of the rate of output.

Whiteside teaches a method of increasing the molecular weight of epoxy resin by reacting an epoxy resin composed of a glycidyl ether of a dihydric phenol having more than one glycidyl ether group per molecule with a dihydric phenol in the presence of a phosphonium catalyst. The ratio of phenolic hydroxyl to epoxy is such that the resulting reaction product will have a theoretical epoxy content (in percent) of from 2.7 to 14. This means (as the examples show), an epoxy equivalents to OH equivalents ratio in the range of 3:1 to 4:1.

Irving describes an IPN based on an anaerobically polymerisable mixture comprising a free radical polymerisable compound, a radical initiator, an accelerator, and an epoxy resin cured with the aid of a base, a polymercaptan, or a polyhydric phenol. Irving makes no mention of IPNs based on allyl compounds.

GB 994,484 teaches a cured composition which in the uncured state comprises an epoxy novolac, the dianhydride of pyromellitic acid, and an unsaturated reactive diluent. The reactive diluent may be triallyl cyanurate, providing no polyol accelerators are employed.

From JP-Hei-4-216818 resin compositions are known that comprise, int.al., an epoxy terminated allyl-containing prepolymer and a hydroxyl terminated allyl-containing prepolymer.

JP-Hei-4-108860 teaches a thermosetting composition obtained by blending a thermosetting resin such as an epoxy resin with triallyl isocyanurate and triallyl isocyanurate prepolymer. The disclosure leaves open desires similar to those left open by the disclosure of US 5,210,157 cited above.

The discussed literature references teach neither IPNs of the aforementioned type, nor the desired improvements of these IPNs. These improvements are provided by the present invention. To this end the invention consists in that in an IPN of the aforementioned known type the epoxy network forming compounds (la) and (1b) are in a non-stoichiometric ratio to each other, such that the percentage of stoichiometry is in the range of 10 to 80%, the percentage of stoichiometry being defined as 100% times the quotient of the number of hydroxyl equivalents to the number of epoxy equivalents.

The epoxy network in the present IPNs is built up from polyfunctional epoxy compounds (epoxy resin) cross-linked with polyfunctional aromatic hydroxyl compounds.

By the term "epoxy resin" is meant a curable composition of oxirane ring-containing compounds. Such compounds have been described in C.A. May, Epoxy Resins, 2nd Edition (New York & Basel: Marcel Dekker Inc., 1988).

As examples of epoxy resins may be mentioned phenol types, such as those based on the diglycidyl ether of Bisphenol-A, on polyglycidyl ethers of phenol-formaldehyde novolac or cresol-formaldehyde novolac, on the triglycidyl ether of tris(p-hydroxyphenol)methane, or on the tetraglycidyl ether of tetraphenyl ethane; amine types, such as those based on tetraglycidyl methylene dianiline or on the triglycidyl ether of p-aminoglycol; cycloaliphatic types, such as those based on 3,4-epoxycyclohexylmethyl-3,4-epoxycyclohexane carboxylate.
By the term "epoxy resin" are also meant reaction products of compounds containing an excess of epoxy (e.g., of the types indicated above) and aromatic dihydroxy compounds. These dihydroxy compounds may be halogen substituted.

Preference is given to epoxy resins of the phenol type, especially because of their low price.

It should be noted that, usually, epoxy resins are illustrated by a single unequivocal structural formula. Differing products resulting from side reactions which occur in the preparation of epoxy resins should, as the skilled person knows, be considered to be included therein. As these side products form a standard constituent of cured epoxy resins, so they make up a standard constituent of the IPNs according to the invention.

Generally, an accelerator is employed when cross-linking the epoxy resin. As suitable accelerators may be mentioned imidazoles, more particularly alkyl substituted imidazoles such as 2-methyl imidazole and 2-ethyl-4-methyl imidazole, and tertiary amines such as benzyl dimethyl amine.

The quantity in which such an accelerator is employed is dependent on the type of epoxy resin, the type of cross-linking agent, and the type of accelerator, but it will generally be in the range of 0,01 to 5 wt.%, calculated on the overall weight of epoxy resin and cross-linking agent.

Examples of polyfunctional aromatic hydroxyl compounds include dihydroxy compounds having formulae such as given in US Patent Specification 5,210,157. Further, novolac resins such as phenol/formaldehyde, cresol/formaldehyde, or phenol/p-hydroxybenzaldehyde may act as polyfunctional aromatic hydroxyl cross-linking agents.

The preferred cross-linking agents for the epoxy resin are sulphone diphenol and tetrabromo-Bisphenol-A.

A key element of the present invention resides in that the polyhydric phenol cross-linking agent is used in such an amount as will result in a hydroxy groups to epoxy groups ratio in the range of 0.1:1 to 0.8:1 (10 to 80% stoichiometry). When there is more than 80% stoichiometry, the Tg enhancing effect according to the invention occurs hardly if at all, while with less than 10% stoichiometry phase separation of the two networks is observed, resulting in inferior thermal properties. Moreover, too much excess epoxy will give rise to insufficient fire retardancy.

Preferably, the percentage of stoichiometry is in the range of 30 to 70%, primarily because in this range, favourable low thermal coefficients of expansion (TCEs) are obtained, as well as, of course, a high Tg. The most favourable combination of high Tg and low TCE is achieved when the percentage of stoichiometry is in the range of 40 to 60%.

As examples of suitable allyl monomers turned into an allyl polymer network by means of radical cross-linking may be mentioned triallyl cyanurate (TAC), triallyl isocyanurate (TAIC); aromatic polyallyl esters, such as diallyl phthalate, diallyl isophthalate, triallyl trimellitate, tetraallyl pyromellitate, diallyl tetrabromophthalate; aliphatic polyallyl esters, such as diallyl adipate, diallyl maleate, diallyl fumarate, and polyallyl carbonates such as diethylene glycol diallyl carbonate.

Alternatively, mixtures of allyl monomers and allyl prepolymers may be employed in the preparation of IPNs according to the invention.

For partial replacement of the polyallyl compounds in the IPN use may be made of aromatic difunctional methacrylates such as described in US 5,210,157. The use of 2,2-di (4-methacryloxy-ethoxyphenyl)propane (BMEPP) is preferred.

However, it is of importance to have the allyl compounds present in the IPNs according to the invention in an amount of at least 5% (percent by weight of the solvent-free resin). Preferably, these allyl compounds are cyclic moiety-containing allyl compounds, and even when the IPN contains more than 5% of allyl constituents, it is desired to have at least 5% of cyclic moiety-containing allyl compounds present in the IPN, notably nitrogen-containing allyl compounds such as TAC and TAIC.

Polymerisation of the polyallyl compounds is generally carried out under the influence of an initiator, which will commonly be used in a ratio of 0.1-5 wt.% vis-à-vis the allyl compound. As suitable initiators may be mentioned peroxides, such as t-butylperoxy benzoate, t-butylperoxy-3,5,5-trimethyl hexanoate, and benzoyl peroxide. Alternatively, it is possible to have thermal polymerisation without an initiator.

Generally, an organic solvent will be used in the preparation of IPN resins according to the invention. An advantage of the use of TAC as an IPN constituent is that it can also act as a solvent. If an additional solvent is employed, the epoxy resin, the cross-linking agent, and the polyallyl compound must be soluble therein, while the solvent itself has to be sufficiently volatile to volatilize prior to or during partial curing of the IPN, or prior to final curing.

Suitable solvents are, e.g., dimethyl formamide; glycol ethers, such as ethylene or propylene glycol monoethyl ether, and esters thereof such as ethylene glycol monoethyl ether acetate; ketones, such as methyl isobutyl ketone, methylethyl ketone, acetone, and methyl isopropyl ketone; aromatic hydrocarbons such as toluene and xylene. Use may also be made of mixtures of solvents. The preferred solvents are ketones, notably acetone and methylethyl ketone, and mixtures thereof with ethers, notably propylene glycol monoethyl ether.

As also holds for the known IPNs, halogen substituents may be introduced into the various IPN components. This is to render the IPN sufficiently fire retardant. Preferably a fire retardancy providing amount of bromine is employed to this end. In the case of the IPNs described in US 5,210,157, the use of TAC or TAIC is known to give good fire retardancy at a lower bromine percentage (in the case of an IPN comprising 70% of TAC, ca. 10 wt.% of bromine instead of ca. 18 wt.%), which is very pleasant for environmental reasons. For the IPNs according to the present invention it was found that, because of the use of non-stoichiometric epoxy resin, less than about 14 wt.% of bromine will suffice also in embodiments containing more than 50% of epoxy resin (and, hence, comparatively little TAC). For attaining fire retardancy at a low bromine percentage it is preferred to have a percentage of stoichiometry in the range of 30 to 40% and the percentage of bromine in the IPN does not exceed 15 weight %.

The invention further pertains to laminates for use in the electronics industry into which IPNs of the type described above have been incorporated.

Laminates for use in the electronics industry (notably for printed wiring boards) are generally manufactured by impregnating a supporting or reinforcing material (usually on a glass fibre basis, either in fabric form or in the form of a cross-ply laminate of unidirectionally oriented parallel filaments) with a resin, followed by wholly or partially curing the resin. The latter form is the most conventional one, and a fabric impregnated with a partially cured resin is commonly called a prepreg. Manufacturing a printed wiring board from a fabric prepreg involves laminating one or more layers of the prepreg with one or more layers of, say, copper.

As a rule, the resin employed will be an epoxy resin. Presently, the standard in actual practice is the FR4 laminate, which is based on a brominated epoxy resin prepared from a diglycidyl ether of Bisphenol-A and tetrabromo Bisphenol-A, dicyanodiamide as hardener, an organic solvent, an accelerator, and a catalyst. Such an epoxy resin has the drawback of a low Tg (110°-135°C), however, and there is also a tendency on the part of the dicyanodiamide to crystallise in the resin and in the prepreg made from the resin.

The IPN resins according to the invention are highly suited to be used for the impregnation of, int. al., fabric and cloth of a wide range of materials, such as glass, quartz, carbon, aramid, and boron fibres, especially for making laminates for printed wiring boards, for which application the IPN is preferably employed in combination with a glass fabric.

As is already known from US 5,210,157, when the copper peel strength is of considerable importance, it is preferred to incorporate the largest possible epoxy resin constituent into IPNs of the allyl/epoxy type. Whereas in the known IPNs the optimum allyl polymer to epoxy resin ratio is in the range of 30:70 to 40:60 so as to retain favourable thermal properties, the IPNs according to the present invention not only display superior thermal properties at these ratios but also permit the incorporation of a larger epoxy resin constituent into tne IPN while retaining these thermal properties. In this connection an epoxy resin to allyl compounds weight ratio in the range of 90:10 to 60:40 is preferred for IPNs to be used in metallised laminates.

The invention therefore also relates to a laminate comprising at least a plastic layer and a layer of metal, wherein the plastic layer is composed of an IPN according to this invention, which may be fibre-reinforced or not. Preferably the laminate is characterized in that the epoxy compound to allyl compounds weight ratio in the IPN is in the range of 90:10 to 60:40. The invention further comprises a printed wiring board (PWB) manufactured from said laminate.

Furthermore, the IPN resins according to the invention may be used wherever conventional epoxy resins are employed: as glue, coating, moulding resin, embedding resin, encapsulating resin, sheet moulding compound, bulk moulding compound.

In addition to the aforementioned application as a composite for printed wiring boards the IPN resins according to the invention may be employed to make composites for use in, say, the construction business and the aviation and car industries.

The manufacture of suitable structural composites may be in the known manner, e.g., by impregnating reinforcing material with molten or dissolved resin or by means of resin transfer moulding, filament winding, pultrusion, or RIM (reaction injection moulding).

The IPN resins according to the invention may contain such conventional additives as dyes or pigments, thixotropic agents, flow regulators, and stabilisers.

The invention will be illustrated with reference to the following unlimitative examples below.

### Example 0

### Preparation of the TAC prepolymer used in the examples

To 1.6 kg of molten TAC (= triallyl cyanurate) monomer in a reactor (fitted with a cooler, a stirrer, and a feeder funnel) were added 252 g of MEK and 20 g of carbon-tetrabromide. Next, the contents of the reactor were heated to 95°C, with stirring, and a solution of 28.0 g of dioctanoyl peroxide in 210 g of MEK (methylethyl ketone) was added dropwise over a period of two hours. After a total reaction time at 95°C of six hours 0.16 g of 2,6-di-tertiary butyl-p-cresol was added to the solution, which was then cooled to room temperature.

The 78% TAC prepolymer solution comprising 22 wt.% of MEK had a viscosity of 150 mPa.s. HPLC measurement showed 40% of the monomer to have been converted into oligomer having, relative to polystyrene standards, a number average molecular weight of 7000 and a degree of dispersion of 20.

### Example 1

A mixture was prepared of 27.6 g (0.120 epoxy equivalents) of cresol formaldehyde novolac polyglycidyl epoxy resin (CNE for short, with an epoxy equivalent weight of 230 and a functionality of 4), 32.4 g (0.119 hydroxyl equivalents) of tetrabromobisphenol A, 22.0 g of MEK, and 51.3 g of a TAC prepolymer solution prepared as specified in Example 0. The part by weight of TAC prepolymer in the mixture was 40%, the part by weight of epoxy plus tetrabromobisphenol A (TBBPA) was 60%. The percentage of stoichiometry, i.e., the ratio of hydroxyl equivalents to epoxy equivalents times 100%, was 99.2%. To the solution, which contained 25.0 wt.% of MEK, was added 0.6 g of a 10 wt.% solution of 2-methyl imidazole in 2-methoxy-1-propanol and subsequently 0.4 g of tertiary-butylperoxy benzoate. Next, the resin solution was poured into aluminium dishes in such a way as to give a layer thickness for the resin solution of 0.5 to 1 mm. The samples were then heated to 60°C in a forced-circulation air oven and kept at 60°C for one hour. The temperature of the oven was then raised to and kept for 30 minutes at 100°C, followed by one hour at 120°C and, finally, one hour at 170°C. After the orangish-brown, homogeneously transparent plates had been cooled slowly and released from the mould, the samples were post-cured for a further two hours at 200°C and then cooled slowly to room temperature. The properties of the flat, cured plates are listed in Table 1 under composition A.

The same preparative process was used for compositions B through H, which are also listed in Table 1. Compositions A through H all have the same portion of TAC prepolymer but different percentages of stoichiometry.

### Example 2

Prepared were a prepreg and laminates based on a resin solution composed of:
- 580 g of a 65%-solution of 233 g of CNE epoxy resin (the same type as in Example 1) and 144 g of tetrabromobisphenol A in MEK;
- 322 g of a 78%-solution of TAC prepolymer in MEK;
- 3.8 g of a 10%-solution of 2-methyl imidazole in 2-methoxy-1-propanol; and
- 2.5 g of t-butylperoxy benzoate.

The 70%-resin solution,which contained 40 parts of TAC prepolymer versus 60 parts of epoxy plus TBBPA, had a viscosity of 100 mPa.s determined in accordance with the instructions by Brookfield at a temperature of 20°C. The quantity of TBBPA hydroxyl groups was 52% of the stoichiometric amount required for the presented epoxy groups.

In a laboratory treater E-glass fabric of type 7628 (finishing agent Z 6040) was continuously impregnated with the resin solution at a temperature of 170°C, with the solvent being removed and the resin being partially cured to the B stage. The appearance of the prepregs was excellent and they were non-sticky. The rate at which the fabric was fed to the treater was set such as to give a resin weight percentage and a percentage of resin flow in the prepreg of 44 ± 3 and 22 ± 3, respectively. The weight percentage and the percentage of flow of the resin at 171°C were determined conventionally in accordance with IPC methods TM 650 2.3.16 and 2.3.17 (IPC = Institute for interconnecting and packaging electronic circuits).

Eight prepregs stacked one on top of the other were moulded in a vacuum press at a specific pressure of 1519,875 kPa (15 atm.) and a temperature of 171°C for 60 minutes. Heating and cooling was at a rate of 5°C/minute. In this manner both a laminate coated on either side with copper (28.35 g (1 ounce), electrodeposited type) and an uncoated laminate having a thickness in the range of 1.50 to 1.60 mm were made. All laminates were subjected to two hours of additional post-curing in an oven at 200°C.

The properties of the laminate and of reference laminate 1 are listed in Table 2. The reference laminate, which was prepared as specified in Example 2, is based on the same composition as in Example 2, except that 89% of the stoichiometric amount of TBBPA was employed.

### Example 3

In a manner analogous to that described in Example 2 several laminates were made, with the TAC prepolymer content in the resin being varied vis-à-vis the CNE epoxy plus TBBPA content, and with the percentage of stoichiometry being kept constant at 52%. The data is listed in Table 3 along with that of two reference examples. viz. 2 and 3.

### Example 4

Based on phenol-formaldehyde novolac polyglycidyl epoxy resin (FNE for short) having an average epoxy functionality of 3.5 and an epoxy equivalent weight of 178, a resin was formulated as follows:
- 2151 g of a 70%-solution of 855 g of FNE epoxy resin and 645 g of TBBPA in MEK;
- 1283 g of a 78%-solution of TAC prepolymer in MEK;
- 15 g of a 10%-solution of 2-ethyl,4-methyl imidazole in MEK;
- 10 g of t-butylperoxy benzoate.

The 73%-resin solution, which contained 40 parts of TAC prepolymer versus 60 parts of epoxy plus TBBPA, had a viscosity of 80 mPa.s determined in accordance with the instructions by Brookfield at a temperature of 20°C. The quantity of TBBPA hydroxyl groups was 49% of the stoichiometric amount required for the presented epoxy groups.

In a manner analogous to that described in Example 2 this resin was processed into prepregs and laminates. Its composition and thermal properties are compiled in Table 4 as Example 4A. This table also lists the composition and results for two similar resins, Examples 4B and 4C, characterised in that they had a stoichiometry percentage of 25% and 79%, respectively. It should be noted that in Example 4B the prepregs were moulded into a laminate in an autoclave, instead of in a vacuum press as in the other examples, because the resin flow was too high and the desired thickness of 1.5 to 1.6 mm was therefore not achieved.

### Example 5

A resin was formulated from:
- 3277 g of a 55%-solution of 1113 g of CNE epoxy resin and 687 g of TBBPA in MEK;
- 600 g of triallyl cyanurate monomer;
- 600 g of (ortho-)diallyl phthalate prepolymer (DAP prepolymer), commercially available from Osaka Soda Co., having ≤ 3% monomer and an iodine number of 60;
- 18 g of a 10%-solution of 2-methyl imidazole in 2-methoxy-1-propanol;
- 12 g of t-butylperoxy benzoate.

The 67%-resin solution, which contained 20 parts of TAC monomer and 20 parts of DAP prepolymer versus 37.1 parts of epoxy and 22.9 parts of TBBPA, had a viscosity of 110 mPa.s determined in accordance with the instructions by Brookfield at a temperature of 23°C. The quantity of TBBPA hydroxyl groups was 52% of the stoichiometric amount required for the presented epoxy groups.

In a manner analogous to that described in Example 2 this resin was processed into prepregs and laminates. The results are given in Table 5.

**Table 1**

| Composition | A | B | C | D | E | F | G | H |
|---|---|---|---|---|---|---|---|---|
| % stoichiometry | 99.3 | 78.5 | 57.4 | 52.2 | 36.8 | 26.1 | 5.3 | 0 |
| | | | | | | | | |
| Composition | | | | | | | | |
| % CNE epoxy res. | 27.6 | 31.1 | 35.7 | 37.1 | 41.9 | 45.8 | 56.5 | 60.0 |
| % TBBPA | 32.4 | 28.9 | 24.3 | 22.9 | 18.1 | 14.2 | 3.5 | -- |
| % TAC prepol. | 40.0 | 40.0 | 40.0 | 40.0 | 40.0 | 40.0 | 40.0 | 40.0 |
| | | | | | | | | |
| epoxy equivalents | 0.120 | 0.135 | 0.155 | 0.161 | 0.182 | 0.199 | 0.246 | 0.261 |
| hydroxyl equivalents | 0.119 | 0.106 | 0.089 | 0.084 | 0.067 | 0.052 | 0.013 | 0 |
| | | | | | | | | |
| % bromine¹ | 19.5 | 17.5 | 14.7 | 14.0 | 11.1 | 8.8 | 2.6 | 0.5 |
| | | | | | | | | |
| Tg (°C) by TMA | 155 | 173 | 190 | 190 | 190 | 185 | 2Tg's² | 2Tg's³ |
| | | | | | | | | |
| T.C.E. (ppm/°C average over 20°-250°C) | 130 | 130 | 100 | 102 | 110 | 120 | 190 | ≥210 |
| | | | | | | | | |
| TGA (N2 atm.) | | | | | | | | |
| * loss at 300°C (%) | 1.7 | | | 1.6 | | | 1.5 | 1.5 |
| * decomposition maximum (°C) | 325 | | | 326 | | | 383 | 405;537 |
| * residual at 650°C (%) | 25 | | | 24.2 | | | 17.0 | 0.5 |
| | | | | | | | | |
| flame test, fire retardant? | yes | yes | yes | yes | yes | yes/no | no | no |

| | | | | | | | | |
|---|---|---|---|---|---|---|---|---|
| ¹) calculated bromine content (%) in composition exclusive of MEK | | | | | | | | |
| ²) 2 Tgs, 170° and 220°C | | | | | | | | |
| ³) 2 Tgs, sample is still curing: first run 130° and 220°C, second run 170° and 220°C | | | | | | | | |

**Table 2**

| | Example 2 | Reference 1 |
|---|---|---|
| Resin composition: | | |
| | | |
| % TAC prepolymer | 40 | 40 |
| % CNE epoxy resin | 37.1 | 29.3 |
| % TBBPA | 22.9 | 30.7 |
| | | |
| % stoichiometry | 52 | 89 |
| % bromine | 13.9 | 18.5 |
| Laminate: | | |
| | | |
| Tg (°C) | | |
| | | |
| * by TMA | 185 | 160 |
| | | |
| * DMTA (damping maximum) | 235 | 210 |
| | | |
| T.C.E.z. (ppm/°C) average (over 20°-250°C) | 100 | 120 |
| | | |
| fire retardancy UL94, class | V0 | V0 |

**Table 3**

| | Ex. 3A | Ex. 3B | Ex. 2 | Ref.2 | Ref.3 |
|---|---|---|---|---|---|
| Resin composition: | | | | | |
| | | | | | |
| % TAC prepolymer | 10 | 20 | 40 | 20 | 0 |
| % CNE epoxy resin | 55.6 | 49.4 | 37.1 | 39 | 62.8 |
| % TBBPA | 34.4 | 30.6 | 22.9 | 41 | 37.2 |
| | | | | | |
| % stoichiometry | 52 | 52 | 52 | 89 | 50 |
| % bromine | 20.3 | 18.3 | 14 | 24.4 | 21.9 |
| Laminate properties: | | | | | |
| | | | | | |
| Tg (°C) | | | | | |
| * by TMA | 165 | 175 | 185 | 153 | 138 |
| * DMTA (damping max.) | 185 | 200 | 235 | 195 | 160 |
| T.C.E.z (ppm/°C) average (over 20°-250°C) | 145 | 130 | 100 | 155 | 200 |
| | | | | | |
| dielectric constant at 1 MHz | 4.3 | 4.3 | 4.3 | 4.4 | 4.4 |
| | | | | | |
| dissipation factor at 1 MHz | 0.011 | 0.012 | 0.011 | 0.009 | 0.012 |
| water absorption % | 0.15 | 0.12 | 0.15 | 0.10 | 0.10 |
| dichloromethane absorption after 30' | 0.07 | 0.09 | 0.10 | 0.05 | 0.21 |
| Copper peel strength (N/cm) | | | | | |
| - as such | 15.8 | 12.6 | 14.3 | 11.4 | 17.4 |
| - after solder bath 10" (288°C) | 15.8 | 12.2 | 14.5 | 12.2 | 17.2 |
| Fire retardancy UL94, class | V0 | V0 | V0 | V0 | V0 |

**Table 4**

| | Example 4A | Example 4B | Example 4C |
|---|---|---|---|
| Resin composition: | | | |
| | | | |
| % TAC prepolymer | 40 | 40 | 40 |
| % FNE epoxy resin | 34.2 | 43.5 | 27.2 |
| % TBBPA | 25.8 | 16.5 | 32.8 |
| | | | |
| % stoichiometry | 49 | 25 | 79 |
| % bromine | 15.7 | 10.2 | 19.8 |
| | | | |
| Laminate: | | | |
| | | | |
| Tg (°C) | | | |
| | | | |
| * by TMA | 177 | 177 | 164 |
| | | | |
| * DMTA (damping maximum) | 220 | 200 | 210 |
| | | | |
| T.C.E.z (ppm/°C) average (over 20-250°C) | 100 | 100 | 105 |

**Table 5**

| | Example 5 |
|---|---|
| Resin composition: | |
| % TAC monomer | 20 |
| % DAP prepolymer | 20 |
| % GNE epoxy resin | 37.1 |
| % TBBPA | 22.9 |
| | |
| % stoichiometry | 52 |
| % bromine | 14 |
| Laminate properties: | |
| | |
| Tg (°C) | |
| * by TMA | 157 |
| * DMTA (damping maximum) | 190 |
| T.C.E.z (ppm/°C) average (over 20-250°C) | 150 |
| dielectric constant at 1 MHz | 4.2 |
| | |
| dissipation factor at 1 MHz | 0.012 |
| water absorption % | 0.11 |
| dichloromethane absorption after 30' | 0.03 |
| Copper peel strength (N/cm) | |
| - as such | 14.1 |
| - after solder bath 10" (288°C) | 13.1 |
| Fire retardancy UL94, class | V0 |

## Claims

1. An interpenetrating polymer network (IPN) composed of
(1) epoxy network forming compounds comprising
(a) polyfunctional epoxy compounds;
(b) polyfunctional aromatic hydroxyl compounds;
(2) allyl network forming compounds;
in which the (1):(2) weight ratio is in the range of 95:5 to 40:60, characterised in that the epoxy network forming compounds (1a) and (1b) are in non-stoichiometric ratio to each other, such that the percentage of stoichiometry is in the range of 10 to 80%, the percentage of stoichiometry being defined as 100% times the quotient of the number of hydroxyl equivalents to the number of epoxy equivalents.

2. An IPN according to claim 1, characterised in that the percentage of stoichiometry is in the range of 30 to 70%.

3. An IPN according to claim 2, characterised in that the percentage of stoichiometry is in the range of 40 to 60%.

4. An IPN according to any one of the preceding claims, characterised in that the epoxy network contains a fire retardancy providing amount of bromine.

5. An IPN according to claim 4, characterised in that the percentage of stoichiometry is in the range of 30 to 40%, and the percentage of bromine in the IPN does not exceed 15 weight%.

6. An IPN according to any one of the preceding claims, characterised in that it comprises at least 5 wt.% of a cyclic moiety-containing allyl compound.

7. An IPN according to claim 6, characterised in that it comprises triallyl cyanurate as cyclic moiety-containing allyl compound.

8. A laminate comprising at least a plastics layer and a layer of metal, characterised in that the plastics layer is composed of an IPN according to any one of the preceding claims which may be fibre-reinforced or not.

9. A laminate according to claim 8, characterised in that the epoxy compounds to allyl compounds weight ratio in the IPN is in the range of 90:10 to 60:40.

10. A printed wiring board (PWB) manufactured from a laminate according to claim 8 or 9.

## Patentansprüche

1. Interpenetrierendes Polymernetzwerk (IPN), zusammengesetzt aus
(1) Verbindungen, die ein Epoxynetzwerk bilden, enthaltend
(a) polyfunktionelle Epoxyverbindungen;
(b) polyfunktionelle aromatische Hydroxylverbindungen;
(2) Verbindungen, die ein Allylnetzwerk bilden;
worin das (1):(2)-Gewichtsverhältnis im Bereich von 95:5 bis 40:60 liegt, dadurch gekennzeichnet, dass die das Epoxynetzwerk bildenden Verbindungen (1a) und (1b) in einem nicht-stöchiometrischen Verhältnis zueinander vorliegen, derart, dass der Prozentwert der Stöchiometrie im Bereich von 10 bis 80% liegt, wobei der Prozentwert der Stöchiometrie als 100% mal den Quotient der Anzahl Hydroxyläquivalente zur Anzahl Epoxyäquivalente definiert ist.

2. IPN nach Anspruch 1, dadurch gekennzeichnet, dass der Prozentwert der Stöchiometrie im Bereich von 30 bis 70% liegt.

3. IPN nach Anspruch 2, dadurch gekennzeichnet, dass der Prozentwert der Stöchiometrie im Bereich von 40 bis 60% liegt.

4. IPN nach einem der vorangehenden Ansprüche, dadurch gekennzeichnet, dass das Epoxynetzwerk einen flammhemmenden Anteil an Brom enthält.

5. IPN nach Anspruch 4, dadurch gekennzeichnet, dass der Prozentwert der Stöchiometrie im Bereich von 30 bis 40% liegt und der prozentuale Anteil an Brom im IPN 15 Gew.% nicht überschreitet.

6. IPN nach einem der vorangehenden Ansprüche, dadurch gekennzeichnet, dass es mindestens 5 Gew.% einer eine zyklische Gruppe enthaltenden Allylverbindung enthält.

7. IPN nach Anspruch 6, dadurch gekennzeichnet, dass es Triallylcyanurat als Allylverbindung, die eine zyklische Gruppe aufweist, enthält.

8. Laminat, enthaltend mindestens eine Kunststoffschicht und eine Metallschicht, dadurch gekennzeichnet, dass die Kunststoffschicht aus einem IPN gemäss einem der vorangehenden Ansprüche zusammengesetzt und gegebenenfalls faserverstärkt ist.

9. Laminat nach Anspruch 8, dadurch gekennzeichnet, dass das Gewichtsverhältnis von Epoxyverbindungen zu Allylverbindungen im IPN im Bereich von 90:10 bis 60:40 liegt.

10. Gedruckte Schaltung (PWB), hergestellt aus einem Laminat gemäss den Ansprüchen 8 oder 9.

## Revendications

1. Un réseau de polymère interpénétrant (IPN) composé de
(1) des dérivés réticulables époxy comprenant
(a) des dérivés époxy polyfonctionnels;
(b) des dérivés hydroxylés aromatiques polyfonctionnels;
(2) des dérivés réticulables allyliques,
dans lequel le rapport pondéral (1)/(2) est compris entre 95/5 et 40/60, caractérisés en ce que les dérivés réticulables époxy (1a) et (1b) sont en rapport non-stoechiométrique l'un par rapport à l'autre de sorte que le pourcentage de stoechiométrie soit compris entre 10 et 80%, le pourcentage de stoechiométrie étant défini comme étant 100 fois le quotient du nombre d'équivalents hydroxyle par le nombre d'équivalents époxy.

2. Un IPN selon la revendication 1, caractérisé en ce que le pourcentage de stoechiométrie est compris entre 30 et 70%.

3. Un IPN selon la revendication 2, caractérisé en ce que le pourcentage de stoechiométrie est compris entre 40 et 60%.

4. Un IPN selon l'une quelconque des revendications précédentes, caractérisé en ce que le réseau époxy contient une quantité ignifuge de brome.

5. Un IPN selon la revendication 4, caractérisé en ce que le pourcentage de stoechiométrie est compris entre 30 et 40% en poids et le pourcentage de brome dans l'IPN ne dépasse pas 15% en poids.

6. Un IPN selon l'une quelconque des revendications précédentes, caractérisé en ce qu'il comprend au moins 5% en poids d'un dérivé allylique contenant un reste cyclique.

7. Un IPN selon la revendication 6, caractérisé en ce qu'il comprend du cyanurate de triallyle en tant que dérivé allylique contenant un reste cyclique.

8. Un stratifié comprenant au moins une couche de plastique et une couche de métal caractérisé en ce que la couche de plastique est constituée d'un IPN selon l'une quelconque des revendications précédentes qui peut être renforcé ou non par des fibres.

9. Un stratifié selon la revendication 8, caractérisé en ce que le rapport pondéral des dérivés époxy aux dérivés allyliques dans l'IPN est compris entre 90/10 et 60/40.

10. Une carte de circuits imprimés (PWB) fabriquée à partir d'un stratifié selon l'une quelconque des revendications 8 ou 9.
